# EUROPEAN PATENT SPECIFICATION

(11) **EP 2 119 002 B1**
(45) Date of publication and mention of the grant of the patent: **23.05.2012**
(21) Application number: 08708792.0
(22) Date of filing: 07.02.2008
(51) Int. Cl.: H03G 3/00

(54) **A MULTI-RATE TRACKING CIRCUIT**
MEHRRATEN-TRACKING-SCHALTUNG
CIRCUIT DE POURSUITE À DÉBITS MULTIPLES

(30) Priority: 09.02.2007 GB 0702593
(43) Date of publication of application: 18.11.2009
(73) Proprietor: TEXAS INSTRUMENTS LIMITED, Northampton Business Park, Northampton NN4 7YL (GB)
(72) Inventor: LYTOLLIS, Shaun, Silverstone Northamptonshire NN12 8DN (GB)
(74) Representative: Holt, Michael
(86) International application number: PCT/EP2008/051513
(87) International publication number: WO 2008/095985

(56) References cited:
- WO-A-01/24360
- FR-A- 2 763 442
- US-A- 5 036 527
- US-A- 5 563 916
- US-A- 6 038 435
- ANTONI FERTNER ET AL: "An Adaptive Gain Control with a Variable Step Size for Use in High-Speed Data Communication Systems" IEEE TRANSACTIONS ON CIRCUITS AND SYSTEMS II: EXPRESS BRIEFS, IEEE SERVICE CENTER, NEW YORK, NY, US, vol. 44, no. 11, 1 November 1997 (1997-11-01), XP011012724 ISSN: 1057-7130

## Description

This invention relates to a multi-rate tracking circuit.

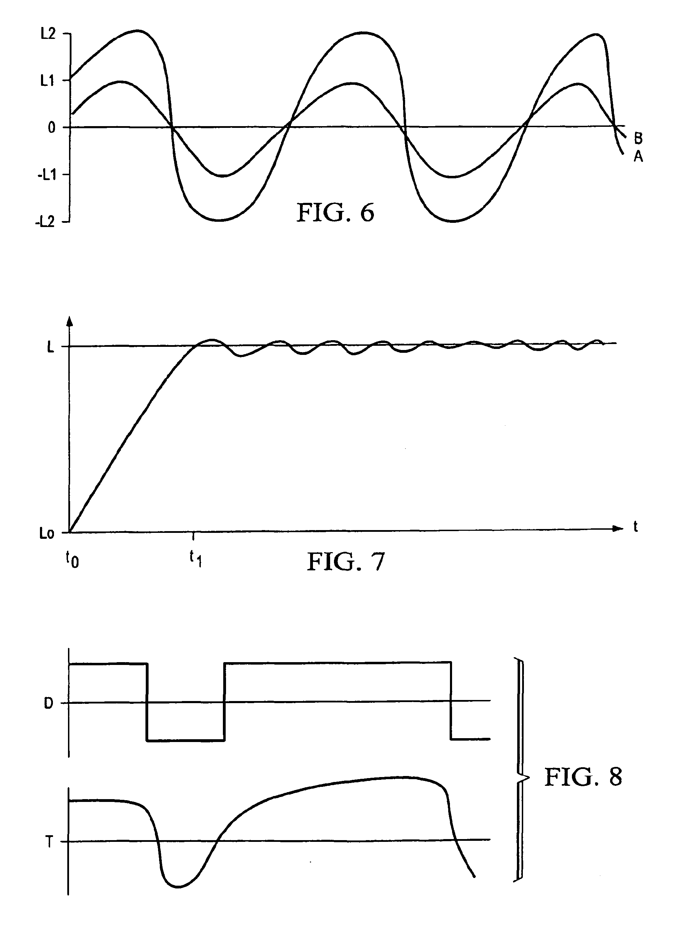

A receiver circuit will often be designed to take an input that moves across a certain range, for example between -L2 and L2 as shown in Figure 6. However, when a data signal is being transmitted to a receiver circuit, the characteristics of the line over which the data is being transmitted will often act to compress the waveform of the digital signal, resulting in a signal that only moves across a smaller range, as shown by signal B in Figure 6, which only moves across the range -L1 to L1. A receiver circuit taking as input such a signal may be prone to errors, or may not work at all. A known solution to this problem is to amplify the input signal so that it moves across the whole desired range. An example of such an amplified input signal is shown by signal A in Figure 6.

In order to amplify the signal by the correct amount, the receiver will incorporate "voting logic", which considers a number of characteristics of the signal and decides whether the amplification level needs to be increased or decreased. Figure 7 shows an example a circuit trying to find an ideal amplification level L*. At time t0 the amplification begins at a base level L0. Between time t0 and t1 the amplification level is below the ideal level L*, and so the voting logic will indicate that the amplification needs to be increased. At time t1 the amplification level reaches the ideal level L*. However, the receiver is not aware that it has hit the correct level, and thus overshoots. However, once it has overshot the voting logic will indicate instead that the amplification level is above the ideal level L*. The amplification level is then reduced until it falls below the ideal level L*, at which point the voting logic indicates again that it is below the ideal level L*. In this way the amplification level will oscillate close to the ideal amplification level L*.

Receiver circuits will often incorporate circuitry to compensate for other effects the characteristics of line over which data is transmitted have on the signal. For example, a receiver circuit that takes a digital signal may adjust the amplitude of the bits of the signal to allow for inter-symbol interference. Inter-symbol interference is distortion of a symbol caused by symbols transmitted before and after it. An example of inter-symbol interference is shown in Figure 8, which shows a signal D that is sent down a line, and the resulting signal T. As can be seen, the line acts to smooth the corners of the signal D when it changes between the high and low state, and a sequence of three high states in the signal D results in a gently rising waveform in the resulting signal T. A common method of allowing for inter-symbol interference is to adjust the amplitudes of the signal T to recover the signal D.

If more than one type of compensation is performed on a signal at the same time, it is necessary to ensure that they do not interfere with each other. A known solution is to have the compensation for the compression of the input signal occur over a much longer time frame than the compensation for inter-symbol interference. For example, while the inter-symbol interference compensation operates on each bit of the input signal in turn, the compression compensation might operate on around a million bits of the input signal. This means that the inter-symbol interference compensation will able to operate without incorrectly trying to compensate for amplitude changes due to the compression compensation.

However, there are two potential problems with having the compression compensation operate over such a long time frame.

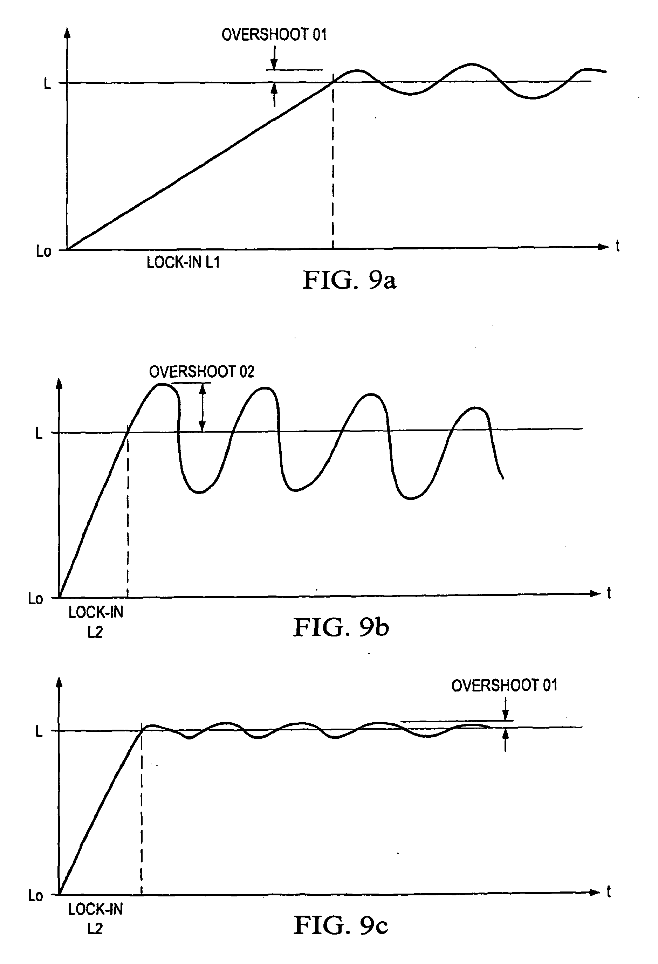

The voting logic only indicates whether the amplification level is above or below the ideal level, and gives no indication of how close it is. If the amount by which the amplification level is varied each time is set at a small value, then as shown in Figure 9a it will take a very long time before the amplification reaches a point near the ideal level and locks in (L1) but after that the overshoot (O1) can be small. If, on the other hand, the amount by which the amplification level is varied each time is set at a large value, then as shown in Figure 9b the lock in will be quick (L2) but amplification level will repeatedly overshoot the ideal level by a large amount (O2).

According to the present invention there is provided a multi-rate tracking circuit and method as set forth in the claims.

Advantageously, the first counter is arranged to vary a value based on the indications received from the voting logic, and to vary the current proposed level when the value varied by the first counter crosses a threshold value.

Preferably, the multi-rate tracking circuit is arranged so that the magnitude of the variation of the value varied by the first counter is dependent upon the value varied by the second counter. Advantageously, the multi-rate tracking circuit is arranged so that the value varied by the second counter is increased in magnitude if the indications from the voting logic cause the proposed level varied by the first counter to be varied consecutively in the same direction. Advantageously, the multi-rate tracking circuit is arranged so that the value varied by the second counter is decreased if the indications from the voting logic cause the proposed level varied by the first counter to be varied consecutively in the different directions. Advantageously, the multi-rate tracking circuit is arranged so that the value varied by the second counter is reset to a default value if the indications from the voting logic cause the proposed level varied by the first counter to be varied consecutively in the different.

Alternatively, the multi-rate tracking circuit is arranged so that the value varied by the second counter is increased in magnitude if consecutive indications of the same direction are received from the voting logic. Advantageously, the multi-rate tracking circuit is arranged so that the value varied by the second counter is decreased if consecutive indications of different directions are received from the voting logic. Advantageously, the multi-rate tracking circuit is arranged so that the value varied by the second counter is reset to a default value if consecutive indications of different directions are received from the voting logic.

The second counter may be arranged to vary a second value based on the indications received from the voting logic, and to vary the first value when the second value crosses a threshold value.

According to the present invention there is further provided a method of tracking a level related to a signal, comprising the steps of: storing a current proposed level, a first value and a second value; determining a desired direction of change in the current proposed level; varying the first value based on the determined direction of change; varying the current proposed level when the first value reaches a threshold value; varying a second value based on the variation of the current proposed level; wherein the magnitude of variation of the first value is dependent upon the second value.

According to the present invention there is further provided a method of tracking a level related to a signal, comprising the steps of: storing a current proposed level, a first value and a second value; determining a desired direction of change in the current proposed level; varying the first value based on the determined direction of change; varying the current proposed level when the first value reaches a threshold value; varying a second value based on the variation of the current proposed level; wherein the threshold value for the first value is dependent upon the second value.

Advantageously, the second value is increased when the proposed level is varied consecutively in the same direction. Advantageously, the second value is decreased when the proposed level is varied consecutively in different directions. Advantageously, the second value is reset to a default value when the proposed level is varied consecutively in different directions.

Examples of the invention will now be described with reference to the accompanying drawings, of which:
Figure 1 is a block diagram a receiver circuit, in which the invention may be used;
Figure 2 shows the feed forward equaliser and the decision feedback equaliser of the receiver circuit of Figure 1;
Figure 3 is a graph showing the post equalised signal amplitude for exemplary bit patterns;
Figure 4 is a diagram of a transmitter;
Figure 5a shows the response of the receiver to a PRBS transmitted eye-pattern;
Figure 5b shows the interleaved output of the ADCs of the receiver;
Figure 6 is a waveform diagram of a compressed input signal and an amplified input signal;
Figure 7 is a graph showing an amplification level approaching an ideal level over time;
Figure 8 is a waveform diagram of a digital signal and a corresponding signal showing inter-symbol interference;
Figure 9a is a graph showing an amplification level approaching an ideal level slowly;
Figure 9b is a graph showing an amplification level approaching an ideal level rapidly;
Figure 9c is a graph showing the approach to an ideal level with the invention;
Figure 10 is a circuit diagram of a circuit according to the present invention.

A key challenge facing designers of high-bandwidth systems such as data-routers and super-computers is the requirement to transfer large amounts of data between ICs - either on the same circuit board or between boards. This data transmission application is called Serialisation-Deserialisation or "SerDes" for short. The present invention is useful in SerDes circuit and indeed was developed for that application. Nonetheless the invention may be used in other applications.

Analysis of typical backplane channel attenuation (which is around -24dB) and package losses (-1 to -2dB) in the presence of crosstalk predict that an un-equalized transceiver provides inadequate performance and that decision feedback equalization (DFE) is needed to achieve error rates of less than 10-17.

Traditional decision-feedback equalization (DFE) methods for SerDes receivers rely on either modifying, in analogue, the input signal based on the data history ["A 6.25Gb/s Binary Adaptive DFE with First Post-Cursor tap Cancellation for Serial backplane Communications" R Payne et al ISSCC · 2005; "A 6.4Gb/s CMOS SerDes Core with feed-forward and Decision Feedback Equalization" M. Sorna et al ISSCC 2005; "A 4.8-6.4Gb/s serial Link for Backplane Applications Using Decision Feedback Equalization" Balan et al IEEE JSSC Nov 2005.] or on having an adaptive analogue slicing level ["Techniques for High-Speed implementation of Non-linear cancellation" S.Kasturia IEEE Journal on selected areas in Communications. June 1991.] (i.e. the signal level at which the circuit decides whether the signal represents a 1 or a 0).

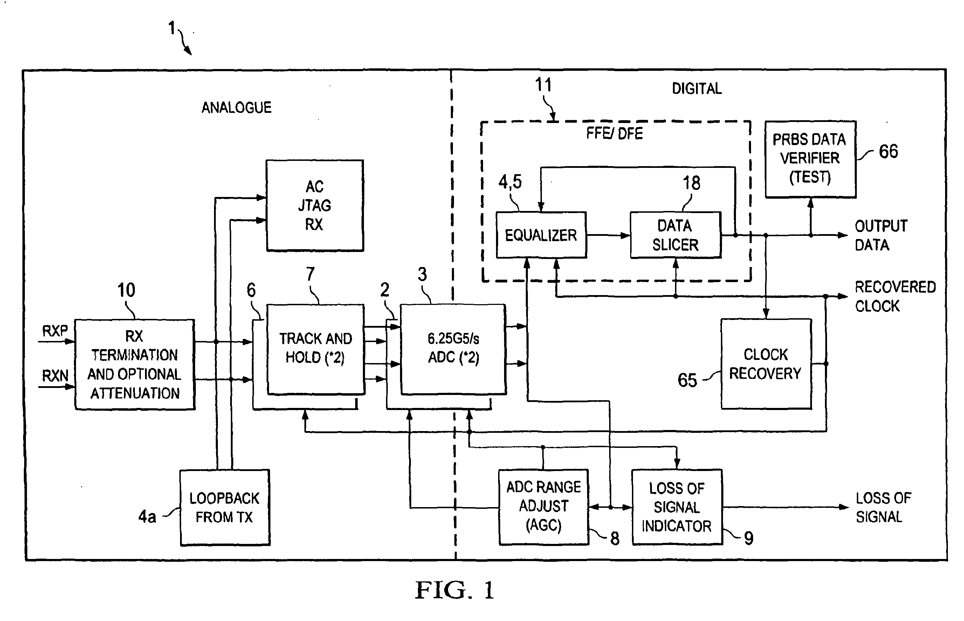

A block diagram of a SerDes receiver circuit 1, which forms part of an integrated circuit, in which the present invention may be used is shown in Figure 1. The invention may nonetheless be used in other applications.

In the receiver circuit 1 of Figure 1 the input data is sampled at the baud-rate, digitized and the equalization and clock & data recovery (CDR) performed using numerical digital processing techniques. This approach results in the superior power/area scaling with process of digital circuitry compared to that of analogue, simplifies production testing, allows straightforward integration of a feed-forward equalizer and provides a flexible design with a configurable number of filter taps in the decision feedback equaliser. The circuit has been implemented in 65nm CMOS, operating at a rate of 12.5Gb/s.

The receiver circuit 1 comprises two baud-rate sampling ADCs (analogue to digital converters) 2 and 3, a digital 2-tap FFE (feed forward equaliser) 4 and digital 5-tap DFE (decision feedback equaliser) 5 to correct channel impairments.

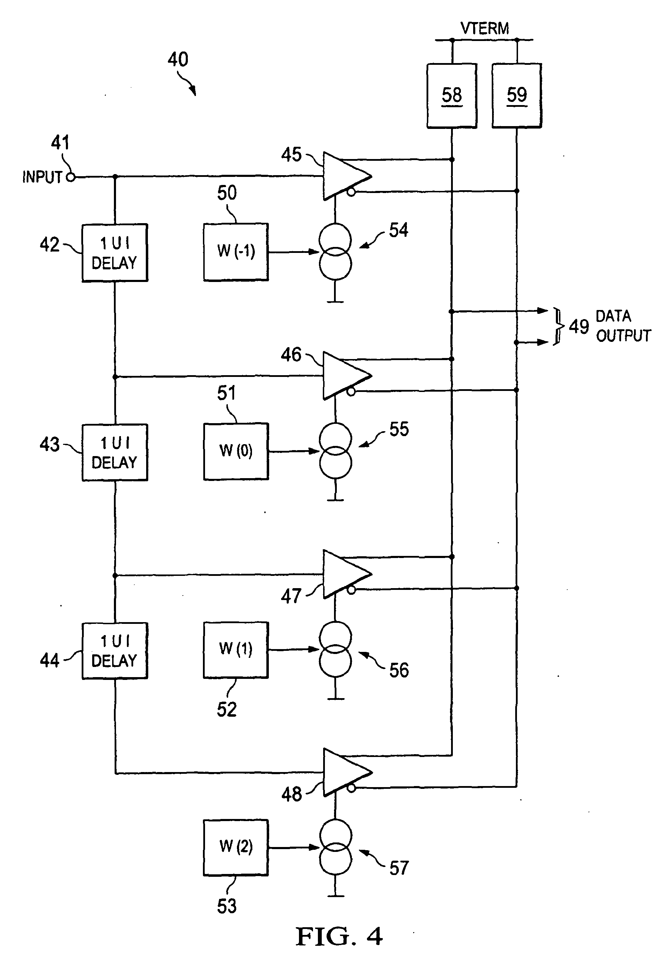

The SerDes section of the integrated circuit, which includes the receiver circuit 1 is also provided with a transmitter 40 (Figure 4), connected to transmit data over a parallel channel to that which the receiver circuit 1 is connected to receive data. The transmitter 40 comprises a 4-tap FIR filter to pre-compensate for channel impairments. In many applications the integrated circuit transmitting data to the receiver circuit 1 uses pre-compensation and in particular a similar transmitter circuit 40, but in other applications the receiver circuit 1 works without pre-compensation being used at the other end

The receiver 1 of Figure 1 is now described in more detail. The received data is digitized at the baud-rate, typically 1.0 to 12.5 Gb/s, using a pair of interleaved track and hold stages (T/H) 6 and 7 and a respective pair of 23 level (4.5 bit) full-flash ADCs 2 and 3 (i.e. they sample and convert alternate bits of the received analogue data waveform). The two track & hold circuits enable interleaving of the half-rate ADCs and reduce signal related aperture timing errors. The two ADCs, each running at 6.25 Gb/s for 12.5 Gb/s incoming data rate provide baud-rate quantization of the received data. The ADC's dynamic range is normalized to the full input amplitude using a 7-bit automatic gain control (AGC) circuit 8. A loss of signal indication is provided by loss of signal unit 9 that detects when the gain control signal provided by the AGC is out-of-range. An optional attenuator is included in the termination block 10, which receives the signals from the transmission channel, to enable reception of large signals whilst minimizing signal overload.

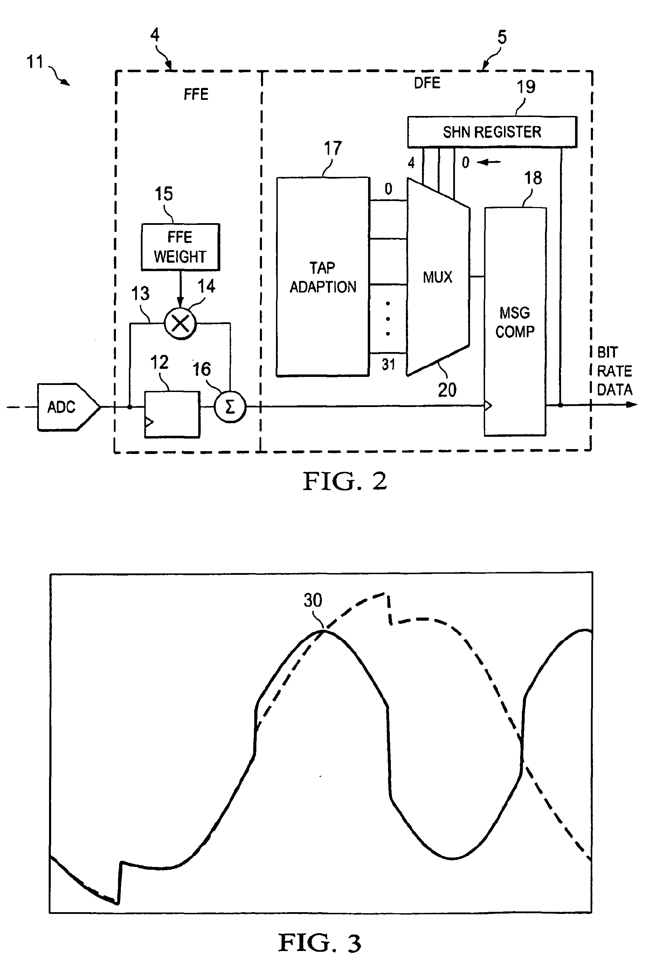

The digital samples output from the ADCs 2 and 3 are interleaved and the resulting stream of samples is fed into a custom digital signal processing (DSP) data-path that performs the numerical feed-forward equalization and decision-feedback equalization. This is shown in Figure 2. This comprises a 1 UI delay register 12 connected to receive the stream of samples from the ADCs 2 and 3. (1 UI is a period of the clock, i.e. the delay between bits.) A tap 13 also feeds the samples from the ADCs to a multiplier 14, each sample being received by the delay latch 12 and the multiplier 14 at the same time. The multiplier 14 multiplies each sample by a constant weight value (held in a programmable register 15), which value is typically 10%. The outputs of the multiplier 14 and the delay register 12 are added together by an adder 16 to provide the output of the FFE 4.

The digital FFE/DFE is implemented using standard 65nm library gates.

An advantage of applying the equalization digitally is that it is straightforward to include feed-forward equalization as a delay-and-add function without any noise-sensitive analogue delay elements. The FFE tap weight is selected before use to compensate for pre-cursor ISI and can be bypassed to reduce latency. Whilst many standards require pre-cursor de-emphasis at the transmitter, inclusion at the receiver allows improved bit error rate (BER) performance with existing legacy transmitters.

The DFE 5 uses an unrolled non-linear cancellation method ["Techniques for High-Speed implementation of Non-linear cancellation" S.Kasturia IEEE Journal on selected areas in Communications. June 1991]. The data output (i.e. the 1s and 0s originally transmitted) is the result of a magnitude comparison between the output of the FFE 4 and a slicer-level dynamically selected from a set stored in a set 17 of pre-programmed registers. The values are determined by a control circuit (not shown in Figure 1) from the waveforms of test patterns sent during a setup phase of operation. The magnitude comparison is performed by a magnitude comparator 18 connected to receive the output of the FFE 4 and the selected slicer-level; it outputs a 1 if the former is higher than the latter and a 0 if it is lower or equal, thereby forming the output of the DFE 5.

The slicer-level is selected from one of 2n possible options depending on the previous n bits of data history. The history of the bits produced by the magnitude comparator 18 is recorded by a shift register 19 which is connected to shift them in. The parallel output of the shift register is connected to the select input of a multiplexer 20 whose data inputs are connected to the outputs of respective ones of the set 17 of registers holding the possible slicer-levels.

Unrolled tap adaption is performed using a least mean square (LMS) method where the optimum slicing level is defined to be the average of the two possible symbol amplitudes (+/-1) when proceeded by identical history bits. (For symmetry the symbols on the channel for the bit values 1 and 0 are given the values +1 and -1).

Although 5-taps of DFE were chosen for this implementation, this parameter is easily scaleable and performance can be traded-off against power consumption and die area. In addition, the digital equalizer is testable using standard ATPG (automatic test pattern generation) and circular built-in-self-test approaches.

The chosen clock recovery approach uses a Muller-Mueller approach ["Timing recovery in Digital Synchronous Data Receivers" Mueller and Muller IEEE Transactions on Communications May 1976.] where the timing function adapts the T/H sample position to the point where the calculated pre-cursor inter-symbol interference (ISI) or h(-1) is zero, an example being given in Figure 3. The two curves show the post-equalized response for 010 and 011 data sequences respectively. The intersection 30 at 3440ps occurs when the sample of the second bit is independent of the third bit - that is, h(-1) = 0. This position can be detected by comparing the post-equalized symbol amplitude with the theoretical amplitude h(0) and using the difference to update the CDR's phase-interpolator.

A block diagram of the transmitter is shown in Figure 4, which is implemented using CML techniques. The data to be transmitted (received at terminal 41) is sequentially delayed by three 1 UI delay registers 42, 43 and 44 connected in series. They produce, via the four taps before and after each delay, a nibble-wide word containing the pre-cursor, cursor and two post-cursor components. In fact to ease timing closure the data is sent to the transmitter from the digital part of the circuit that supplies the data in blocks of 4 nibbles (16 bits in parallel), the blocks being sent at a rate of 3.125/s. Each nibble is a frame of four bits of the bitstream offset by one bit from the next so the nibbles overlap and represent the data redundantly. A multiplexer then selects one of the nibbles, switching between them at a rate of 12.5 x109/s, and presents that in parallel to the four taps, thereby making the bitstream appear to advance along the taps.

A 4-tap FIR output waveform is obtained from simple current summing of the time-delayed contributions. This is done with differential amplifiers 45 to 48, each having its inputs connected to a respective one of the taps and having its differential output connected to a common differential output 49. Although shown as four differential amplifiers the circuit is implemented as one differential amplifier with four inputs, which minimizes return-loss. The relative amplitude of each contribution is weighted to allow the FIR coefficients to be optimized for a given circuit (e.g. a backplane) and minimize the overall residual ISI. The weights are determined empirically either for a typical example of a particular backplane or once a backplane is populated and are stored in registers 50 to 53. The weights respectively control the controllable driving current sources 54 to 57 of the differential amplifiers 45 to 48 to scale their output current accordingly. Respective pull-up resistors 58 and 59 are connected to the two terminals of the differential output 49.

A PLL is used to generate low-jitter reference clocks for the transmitter and receiver to meet standards["OIF-CEI-02.0 - Common Electrical I/O (CEI) - Electrical and Jitter Interoperability agreements for 6G+ bps and 11G+ bps I/O". Optical Internetworking Forum, Feb 2005; "IEEE Draft 802.3ap/Draft 3.0 - Amendment: Electrical Ethernet Operation over Electrical Backplanes" IEEE July 2006.]. Most integrated circuits will have more than one receiver 1 and the PLL is shared between them with each receiver having a phase interpolator to set the phase to that of incoming data.

The PLL uses a ring oscillator to produce four clock-phases at a quarter of the line data-rate. The lower speed clocks allow power efficient clock distribution using CMOS logic levels, but need duty-cycle and quadrature correction at the point of use. The 3.125GHz clocks are frequency doubled (XOR function) to provide the 6.25GHz clock for the T/H & ADC. The transmitter uses the four separate 3.125GHzphases, but they require accurate alignment to meet jitter specifications of 0.15UI p-p R.J. and 0.15UI p-p D.J.

The system described has been fabricated using a 65nm CMOS process and has been shown to provide error-free operation at 12.5Gb/s over short channels (two 11mm package traces, 30cmlow-loss PCB and two connectors). A legacy channel with -24dB of attenuation at 3.75 GHz supports error free operation at 7.5 Gb/s.

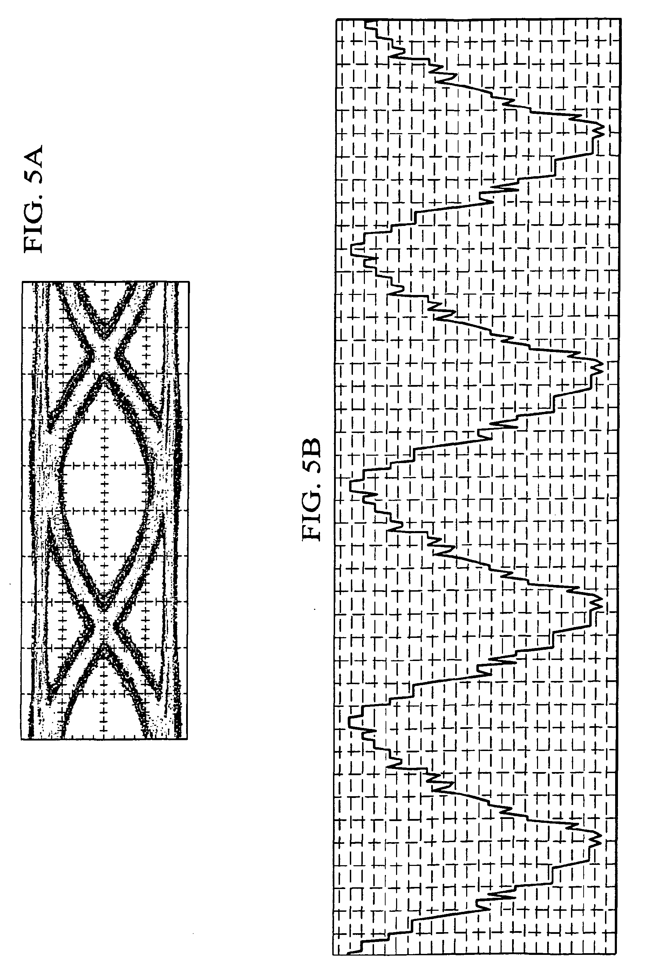

Figure 5a shows a 12.5 Gb/s 27-1 pseudo random bit stream (PRBS) transmitted eye-pattern with 20% de-emphasis on the first post-cursor. The receiver includes, for test purposes, a PRBS data verifier 66, which confirms that the test pattern has been received. The differential peak-to-peak (pp) amplitude is 700mV (200mV/div). Figure 5b shows the ADC output when a 6.25GHz sine-wave is sampled and the phase between the sine-wave and receiver is incremented using a programmable delay-line. The measured codes are within +/-1 lsb (least significant bit) of the expected values. This level of performance ensures robust operation over a wide range of cables, green-field and legacy channels. The worst-case power of a single TX/RX pair, or "lane" is 330mW and the total exemplary macro area is 0.45 mm2 per lane (allowing for the PLL being shared by four TX/RX lanes.

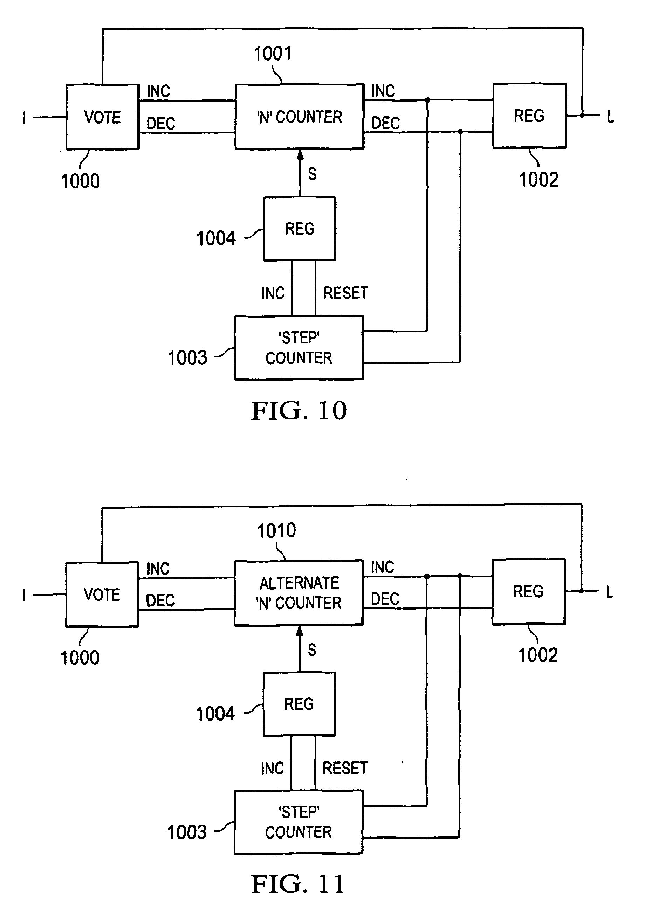

An example of a circuit according to the present invention is shown in Figure 10. A voting logic circuit 1000 takes as input a signal I, the compressed signal which is being compensated, and also the current level of amplification L. The voting logic 1000 has outputs INC and DEC, which are used as input for an 'N' counter (or accumulator) 1001. The `N' counter 1001 has outputs INC and DEC, which are used as input for a 'step' counter 1003 and a register 1002. The output of the register 1002 is L, which is used as an input of the voting logic 1000 as mentioned above. The 'step' counter 1003 has outputs INC and RESET, which are used as inputs for a register 1004. The output of the register 1004 is used as an input for the 'N' counter 1001.

In operation, the voting logic 1000 assesses the input signal I and current level of amplification L, and indicates via its outputs INC and DEC whether the amplification level needs to be incremented (because the current amplification is too low) or decremented (because the current amplification is too high) respectively.

The 'N' counter 1001 operates using a preset threshold value N, which does not change during operation of the circuit. The 'N' counter 1001 stores a value M, which is incremented or decremented according to the inputs from the voting logic 1000. M is incremented or decremented by S, the value of which is set by the register 1004. If M is incremented to above the threshold value N then the 'N' counter 1001 sends an increment signal down its INC output to the register 1002, and M is reset to N/2 (half of N). If M is decremented to below zero then the 'N' counter 1001 sends a decrement signal down its DEC output to the register 1002, and M is reset to N/2 (half of N).

The register 1002 stores the current level L of amplification, which it increments or decrements when it receives a corresponding signal from the 'N' counter 1001.

The 'step' counter 1003 also operates using a preset threshold value P, which again does not change during operation of the circuit. The 'steep' counter stores a value C. Suppose the previous signal received from the 'N' counter 1001 was an increment signal. If the 'steep' counter 1003 receives another increment signal, then C is incremented by 1. Similarly, if the previous signal received from the 'N' counter 1001 was a decrement signal, and the 'step' counter 1003 receives another decrement signal, then C is again incremented by one. If C reaches the threshold value P then the 'step' counter sends an increment signal down its INC output to the register 1004, and C is reset to zero.

However, if the 'step' counter 1003 receives an increment signal when it had previously received a decrement signal, or a decrement signal when it had previously received an increment signal, then it sends a reset signal down its RESET output to the register 1004, and C is again reset to zero.

The register 1004 stores a value S. If the register 1004 receives an increment signal from the 'step' counter 1003 then it increments S. If, on the other hand, it receives a reset signal from the 'step' counter 1003 then it resets S to one.

To see how the circuit works, suppose that initially the value stored in the register 1002 (that is the amplification level L) is L0, and the ideal amplification level is L*. This is the situation shown in Figure 7. Initially the value M stored in the 'N' counter 1001 is set at N/2, the value C stored in the 'step' counter 1003 is zero, and the value S stored in the register 1004 is one.

As the current amplification L is below the ideal amplification L*, the voting logic 1000 will output repeated increment signals. This will repeatedly increment the value M stored in the 'N' counter 1001 by one (as S is one). When M reaches the threshold value N the value L in the register 1002 is incremented, M is reset to N/2, and the cycle repeats. (The voting logic 1000 may due for example to inter-symbol interference output a decrement signal, but these will occur rarely enough that the `N' counter 1001 will always eventually reach the threshold value N.)

At the same time as the above is occurring, each time the 'N' counter 1001 reaches the threshold value N the value C stored in the 'step' counter 1003 is incremented. When C reaches the threshold value P, the value S is incremented. This causes the value M in the 'N' counter 1001 to be incremented more quickly, which in turn causes the amplification level L to be incremented more quickly (as it takes fewer increments from the voting logic 1000 before the value M reaches the threshold value N). Thus it can be seen that the time frame by which the compression compensation circuit operates is reduced as the value S stored in the register 1004 increases. As more consecutive increment signals are output by the 'N' counter 1001 the value of S will continue increasing, causing even greater reduction in the time frame by which the compression compensation circuit operates.

However, once the amplification level L exceeds the ideal amplification level L*, the voting logic 1000 will being to output decrement signals. This will decrement the value M stored in the 'N' counter 1001. Eventually the value M will reach the threshold value of 0, causing the value L in the register 1002 to be decremented. However, as the decrement signal follows an increment signal, it will also cause the 'step' counter 1003 to send a reset signal to the register 1004, which resets S to one. This causes the value M stored in the 'N' counter 1001 to be incremented or decremented by only one, thus returning the operation of the compression compensation circuit to its longest time frame of operation.

It can thus be seen that the circuit of Figure 10 is able to approach an ideal amplification level rapidly when it is far away, but once the ideal level has been reached the rate of change of the amplification level is reduced, preventing the circuit from continually overshooting the ideal level. This is illustrated in Fig 9(c) where a quick lock (L2) is provided along side a low overshoot (O1) It can be seen that the circuit will operate in a similar way when the ideal amplification level L* is lower than the initial amplification level L0.

Another example of a circuit according to the present invention is shown in Figure 11. The circuit is the same as that of the previous example, except that the 'N' counter 1001 has been replaced by and alternate `N' counter 1010. In this case, the alternate 'N' counter 1010 takes as threshold values zero and N-S, outputting a decrement or increment signal when its internal value M crosses those respective thresholds. When a threshold is crossed, M is reset to (N-S)\2. It can be seen that the circuit will operate in much the same way as the circuit of the previous example, except that the time frame of operation of the circuit will be reduced at a slower rate.

It will be appreciated that various other changes to the circuits described could be made which would still be covered by the present invention. For example, the value S stored by the register 1004 could be incremented exponentially (taking the values 1, 2, 4, 8 and so on) rather than by one each time. In a further example, the threshold value P of the `step' counter 1003 could be dependent on the value S stored by the register 1004, for example being reduced as S increases. In a further example, there could be no register 1004, and the increment size S used by the 'N' counter 1001 (or alternative 'N' counter 1010) could be the number of consecutive increment or decrement signals provided by the voting logic 1000. In a further example, the value S stored by the register 1004 could be incremented when consecutive increment or decrement signals are received from the voting logic 1000 rather than the 'N' counter 1001. In a further example, the value S stored by the register 1004 could be incremented when consecutive increment or decrement signals are received from the 'N' counter 1001 as described above; however, instead of being reset when there is a change in signal from the 'N' counter 1001, such a change could have no effect, and the value S could be decremented at regular periods instead. Such a circuit would thus gradually increase its time frame of operation once the ideal level had been reached.

Although this circuit has been described in the context of a compression compensation circuit, it will be appreciated that it is relevant to any situation in which the finding and maintaining of a particular level is required. The level need not be used to vary the signal itself, but could relate to finding a characteristic of the signal, such as its frequency. For example, if the circuit was a phase-locked loop being used to track the frequency of a signal, the voting logic would indicate whether the phase of the circuit was too early or too late.

## Claims

1. A multi-rate tracking circuit, comprising:
an input for a signal (I);
an output arranged to indicate a current proposed amplification level (L)related to the signal;
voting logic (1000) connected to the input, arranged to indicate a direction of change in the current proposed amplification level;
a first counter (1010) connected to the voting logic, arranged to vary the current proposed amplification level based on the indications received from the voting logic;
a second counter (1003), arranged to vary a value based on the indications from the voting logic;
wherein the variation of the current proposed amplification level by the first counter is dependent on the value varied by the second counter so that a threshold value of the first counter is dependent on the value varied by the second counter.

2. A multi-rate tracking circuit as claimed in claim 1, arranged so that the value varied by the second counter is increased in magnitude if the indications from the voting logic cause the proposed amplification level varied by the first counter to be varied consecutively in the same direction.

3. A multi-rate tracking circuit as claimed in claim 2, arranged so that the value varied by the second counter is decreased if the indications from the voting logic cause the proposed amplification level varied by the first counter to be varied consecutively in the different directions.

4. A multi-rate tracking circuit as claimed in claim 3, arranged so that the value varied by the second counter is reset to a default value if the indications from the voting logic cause the proposed amplification level varied by the first counter to be varied consecutively in the different.

5. A multi-rate tracking circuit as claimed in any of claims 1 to 4, arranged so that the value varied by the second counter is increased in magnitude if consecutive indications of the same direction are received from the voting logic.

6. A multi-rate tracking circuit as claimed in claim 6, arranged so that the value varied by the second counter is decreased if consecutive indications of different directions are received from the voting logic.

7. A multi-rate tracking circuit as claimed in claim 6, arranged so that the value varied by the second counter is reset to a default value if consecutive indications of different directions are received from the voting logic.

8. A multi-rate tracking circuit as claimed in any preceding claim, wherein the second counter is arranged to vary a second value based on the indications received from the voting logic, and to vary the first value when the second value crosses a threshold value.

9. A method of tracking a level related to a signal, comprising the steps of:
storing a current proposed amplification level, a first value and a second value;
determining a desired direction of change in the current proposed amplification level;
varying the first value based on the determined direction of change;
varying the current proposed amplification level when the first value reaches a threshold value;
varying a second value based on the variation of the current proposed level;
wherein the threshold value for the first value is dependent upon the second value.

10. A method as claimed in claim 9, wherein the second value is increased when the proposed amplification level is varied consecutively in the same direction.

11. A method as claimed in claim 10, wherein the second value is decreased when the proposed amplification level is varied consecutively in different directions.

12. A method as claimed in claim 11, wherein the second value is reset to a default value when the proposed amplification level is varied consecutively in different directions.

## Patentansprüche

1. Eine Mehrraten-Tracking-Schaltung, bestehend aus:
einer Eingabe für ein Signal (I);
einer Ausgabe konfiguriert, um die verschlagte Stromverstärkungshöhe (L) anzuzeigen, welche Höhe in Zusammenhang mit dem Signal steht;
der Entscheidungslogik (1000) verbundet mit der Eingabe, konfiguriert um eine Richtung der Änderung in der verschlagten Stromverstärkungshöhe anzuzeigen;
einem ersten Zähler (1010) verbundet mit der Entscheidungslogik, konfiguriert um die verschlagte Stromverstärkungshöhe zu ändern, die auf die bekommt von der Entscheidungslogik Anzeichen gegründet wird;
einem zweiten Zähler (1003), konfiguriert um der Wert zu ändern, der auf die von der Entscheidungslogik Anzeichen gegründet wird;
wobei das Anzeichen der verschlagte Stromverstärkungshöhe von dem Wert abhängt, der von dem zweiten Zähler geändert wurde, damit ein Schwellenwert des ersten Zählers von dem Wert abhängt, der von dem zweiten Zähler geändert wurde.

2. Eine Mehrraten-Tracking-Schaltung nach Anspruch 1, konfiguriert damit der von dem zweiten Zähler geänderte Wert erhöht wird, wenn die Anzeichen von der Entscheidungslogik verursachen, die von dem ersten Zähler geänderte verschlagte Verstärkungshöhe forlaufend in gleichen Richtungen geändert zu werden.

3. Eine Mehrraten-Tracking-Schaltung nach Anspruch 2, konfiguriert damit der von dem zweiten Zähler geänderte Wert abgenommen wird, wenn die Anzeichen von der Entscheidungslogik verursachen, die von dem ersten Zähler geänderte verschlagte Verstärkungshöhe forlaufend in verschiedenen Richtungen geändert zu werden.

4. Eine Mehrraten-Tracking-Schaltung nach Anspruch 3, konfiguriert damit der von dem zweiten Zähler geänderte Wert eingeregelt zu einem Voreinstellungswert wird, wenn die Anzeichen von der Entscheidungslogik verursachen, die von dem ersten Zähler geänderte verschlagte Verstärkungshöhe forlaufend in verschiedenen Richtungen geändert zu werden.

5. Eine Mehrraten-Tracking-Schaltung nach Ansprüchen 1-4, konfiguriert damit der von dem zweiten Zähler geänderte Wert erhöht wird, wenn fortlaufende Anzeichen der gleichen Richtung von der Entscheidungslogik bekommt werden.

6. Eine Mehrraten-Tracking-Schaltung nach Anspruch 5, konfiguriert damit der von dem zweiten Zähler geänderte Wert zugenommen wird, wenn fortlaufende Anzeichen von verschiedenen Richtungen von der Entscheidungslogik bekommt werden.

7. Eine Mehrraten-Tracking-Schaltung nach Anspruch 6, konfiguriert damit der von dem zweiten Zähler geänderte Wert eingeregelt zu einem Voreinstellungswert wird, wenn fortlaufende Anzeichen von verschiedenen Richtungen von der Entscheidungslogik bekommt werden.

8. Eine Mehrraten-Tracking-Schaltung nach allen vorhergehenden Ansprüchen, wobei der zweiten Zähler konfiguriert wird, um einen zweiten Wert zu ändern, welcher Wert die auf die bekommt von der Entscheidungslogik Anzeichen gegründet wird , und um einen ersten Wert zu ändern, wenn der zweite Wert einen Schwellenwert übersteigt.

9. Ein Verfahren, um eine Höhe bezüglich eines Signals zu verfolgen, das aus den folgenden Schritten besteht:
Speichern von einer verschlagten Stromverstärkungshöhe, einen ersten Wert und einen zweiten Wert;
die Entscheidung einer erwünschten Richtung von Änderung in der verschalgten Stromverstärkungshöhe;
die Änderung eines ersten Wertes, den auf eine bestimmte Richtung von Änderung gegründet wird;
die Änderung derverschlagten aktuellen Verstärkungshöhe, wenn der erste Wert einen Beschwellenwert reicht;
die Änderung eines zweiten Wertes, den auf die Änderung der verschlagten Stromverstärkungshöhe gegründet wird;
wobei der Schwellenwert für den ersten Wert von dem zweiten Wert abhängt.

10. Ein Verfahren nach Anspruch 9, wobei den zweiten Wert erhöht wird, wenn die verschlagte Verstärkungshöhe in der gleichen Richtung fortlaufend geändert wird.

11. Ein Verfahren nach Anspruch 10, wobei den zweiten Wert zugenommen wird, wenn die verschlagte Verstärkungshöhe in verschiedenen Richtungen fortlaufend geändert wird.

12. Ein Verfahren nach Anspruch 11, wobei den zweiten Wert eingeregelt zu einem Voreinstellungswert wird, wenn die verschlagte Verstärkungshöhe in verschiedenen Richtungen fortlaufend geändert wird.

## Revendications

1. Un circuit de suivi à débits multiples comprenant:
une entrée pour un signal (I);
une sortie configurée pour indiquer un niveau d'amplification de courant proposé (L) lié au signal ;
la logique de vote (1000) branchée à l'entrée, configurée pour indiquer une direction de changement dans un niveau d'amplification de courant proposé;
un premier compteur (1010) branché à la logique de vote, configuré pour varier le niveau d'amplification de courant proposé basé sur les indications reçues de la logique de vote ;
un deuxième compteur (1003) configuré pourvarier une valeur basée sur les indications reçues de la logique de vote ;
où la variation du niveau d'amplification de courant proposé par le premier compteur dépend de la valeur variée par le deuxième compteur pour qu' une valeur de seuil du premier compteur soit dépendante de la valeur variée par le deuxième compteur.

2. Un circuit de suivi à débits multiples selon la revendication 1, configuré pour que la valeur variée par le deuxième compteur soit augmentée en grandeur si les indications de la logique de vote provoquent le niveau d'amplification proposé qui est varié par le premier compteur, d'être varié consécutivement dans la même direction.

3. Un circuit de suivi à débits multiples selon la revendication 2, configuré pour que la valeur variée par le deuxième compteur soit diminuée si les indications de la logique de vote provoquent le niveau d'amplification proposé qui est varié par le premier compteur, d'être varié consécutivement dans les directions différentes.

4. Un circuit de suivi à débits multiples selon la revendication 3, configuré pour que la valeur variée par le deuxième compteur soit réglée à une valeur par défaut si les indications de la logique de vote provoquent le niveau d'amplification proposé qui est varié par le premier compteur, d'être varié consécutivement dans les directions différentes.

5. Un circuit de suivi à débits multiples selon les revendications 1 - 4, configuré pour que la valeur variée par le deuxième compteur soit augmentée en grandeur si les indications consécutives de la même direction sont reçues de la logique de vote.

6. Un circuit de suivi à débits multiples selon la revendication 5, configuré pour que la valeur variée par le deuxième compteur soit diminuée si les indications consécutives des directions différentes sont reçues de la logique de vote.

7. Un circuit de suivi à débits multiples selon la revendication 6, configuré pour que la valeur variée par le deuxième compteur soit réglée à une valeur par défaut si les indications consécutives des directions différentes sont reçues de la logique de vote.

8. Un circuit de suivi à débits multiples selon les revendications précédentes, où le deuxième compteur est configuré pour varier une deuxième valeur basée sur les indications reçues de la logique de vote, et pour varier la première valeur quand la deuxième valeur dépasse une valeur de seuil.

9. Une méthode pour suivre un niveau lié à un signal, comprenant les étapes de :
mémoriser un niveau d'amplification de courant proposé, une première valeur et une deuxième valeur;
établir une direction de changement souhaitée dans le niveau d'amplification de courant proposé;
varier la première valeur basée sur la direction de changement établie ;
varier le niveau d'amplification de courant proposé quand la première valeur atteint une valeur de seuil ;
varier une deuxième valeur basée sur la variation du niveau proposé actuel ;
où la valeur de seuil pour la première valeur est dépendante de la deuxième valeur.

10. Une méthode selon la revendication 9, où la deuxième valeur est augmentée quand le niveau d'amplification proposé est varié consécutivement dans la même direction.

11. Une méthode selon la revendication 10, où la deuxième valeur est diminuée quand le niveau d'amplification proposé est varié consécutivement dans les directions différentes.

12. Une méthode selon la revendication 11, où la deuxième valeur est réglée quand le niveau d'amplification proposé est varié consécutivement dans les directions différentes.
